# EUROPEAN PATENT APPLICATION

(11) **EP 3 703 471 A1**
(43) Date of publication of application: **02.09.2020**
(21) Application number: 18870732.7
(22) Date of filing: 11.10.2018
(51) Int. Cl.: H05B 33/10, H01L 51/44, H01L 51/48, H01L 51/50, H05B 33/02, H05B 33/04, H05B 33/26

(54) **METHOD FOR MANUFACTURING ORGANIC ELECTRONIC DEVICE, AND ORGANIC ELECTRONIC DEVICE**

(30) Priority: 23.10.2017 JP 2017204547
(71) Applicant: SUMITOMO CHEMICAL COMPANY, LIMITED, Chuo-ku Tokyo 104-8260 (JP)
(72) Inventor: SHIMOGAWARA, Masaya, Niihama-shi Ehime 792-0015 (JP); MORISHIMA, Shinichi, Tsukuba-shi Ibaraki 300-3294 (JP); KISHIKAWA, Eiji, Osaka 554-8558 (JP)
(74) Representative: J A Kemp LLP
(86) International application number: PCT/JP2018/037957
(87) International publication number: WO 2019/082675

(57) **Abstract**

According to an embodiment, a method for manufacturing an organic electronic device includes: a step of forming an organic functional layer 16 on a first electrode layer 14 provided for each of device formation regions DA set in a flexible substrate 10 in a first direction; a step of forming a second electrode layer 20 on the flexible substrate, on which the organic functional layer is formed, over the plurality of device formation regions in the first direction in such a way as to cover each organic functional layer; a step of forming a hole 22 by removing, in a second direction crossing the first direction, the second electrode layer provided between a boundary of the device formation region and a function exhibiting design region A1 in the organic functional layer in the first direction or on the second electrode layer on the boundary out of the second electrode layers; and a step of providing a sealing member 26 sealing the function exhibiting design region on the organic functional layer in such a way as to cover a surface of the hole on a side of the function exhibiting design region.

## Description

### Technical Field

The present invention relates to a method for manufacturing an organic electronic device, and an organic electronic device.

### Background Art

An organic electronic device includes a substrate, a first electrode layer, an organic functional layer, and a second electrode layer provided in this order on the substrate, and a sealing member provided on the second electrode layer. As a method for manufacturing such an organic electronic device, a technique disclosed in Patent Literature 1 is known. In the technique disclosed in Patent Literature 1, a flexible substrate provided with a plurality of first electrode layers at a predetermined interval is prepared, and an organic electronic device is manufactured at a position of each of the first electrode layers. In this case, the organic electronic device is formed in a plurality of device formation regions set by arranging the first electrode layers on the flexible substrate. Therefore, after the sealing member is provided, the flexible substrate is diced individually for each of the plurality of device formation regions on the flexible substrate, and thus the organic electronic device having a product size can be obtained.

### Citation List

### Patent Literature

Patent Literature 1: International Publication No. WO 2006/100868

### Summary of Invention

### Technical Problem

As disclosed in Patent Literature 1, when the second electrode layer is formed over the plurality of device formation regions in a case of forming the organic electronic device in each of the device formation region of the flexible substrate, a step of forming the second electrode layer can be shortened, whereby productivity is improved. However, when the organic electronic device having the product size is cut, both ends of the second electrode layer in the arrangement direction of the plurality of device formation regions are exposed. Therefore, the second electrode layer is corroded by moisture, and as a result, performance of the organic electronic device deteriorates.

Accordingly, an object of the present invention is to provide a method for manufacturing an organic electronic device capable of improving productivity and preventing a decrease in performance and an organic electronic device.

### Solution to Problem

According to an aspect of the present invention, a method for manufacturing an organic electronic device includes: an organic functional layer forming step of forming an organic functional layer on a first electrode layer provided in a first direction for each of a plurality of device formation regions set in a flexible substrate; a second electrode layer forming step of forming a second electrode layer on the flexible substrate, on which the organic functional layer is formed, over the plurality of device formation regions in the first direction in such a way as to cover at least a part of each organic functional layer; a hole forming step of forming a hole by removing, in a second direction crossing the first direction, the second electrode layer provided between a boundary of the device formation region and a function exhibiting design region in the organic functional layer in the first direction or on the boundary; and a sealing step of providing a sealing member sealing the organic functional layer on the second electrode layer in such a way as to cover a surface of the hole on a side of the function exhibiting design region.

In the above manufacturing method, the organic electronic device is formed for each of the device formation regions. Therefore, the flexible substrate is diced individually for each of the device formation regions after the sealing step, and thus the plurality of organic electronic devices can be obtained. In the second electrode layer forming step, since the second electrode layer is formed on the flexible substrate over the plurality of the device formation regions in the first direction, a time of the second electrode layer forming step can be shortened. As a result, productivity of the organic electronic device is improved. Since the second electrode layer is formed as described above, for example, when the flexible substrate is diced individually for each of the device formation regions after the sealing step as described above, both ends of the electrode layer in the first direction are exposed in the individually diced organic electronic device. Since the manufacturing method includes the hole forming step, the hole is formed in the electrode layer, located outwards from the function exhibiting design region. Therefore, even when corrosion occurs due to moisture at both ends in the first direction of the second electrode layer in the individually diced organic electronic device, the progress of the corrosion is stopped by the hole. Further, since the surface of the hole on the side of the function exhibiting design region is covered with the sealing member, infiltration of moisture from the surface into the second electrode layer is also prevented. Therefore, since a portion of the second electrode layer on the function exhibiting design region can function as the second electrode function portion, the manufacturing method can also prevent performance deterioration of the organic electronic device.

The flexible substrate may be long, the first direction may be a longitudinal direction of the flexible substrate, and the second electrode layer forming step may be performed while conveying the flexible substrate in the first direction. In this case, since the second electrode layer can be efficiently formed, the productivity of the organic electronic device is further improved.

The second electrode layer forming step and the hole forming step may be performed by a roll-to-roll method.

In the hole forming step, the hole may be formed by irradiating the second electrode layer with a laser beam and removing the second electrode layer. In this case, the hole is easily formed. In particular, it is effective when the flexible substrate is long and the hole forming step is performed while conveying the flexible substrate in a longitudinal direction.

In the sealing step, the sealing member may be provided on the second electrode layer such that a part of the sealing member is filled in the hole. This makes it possible to more reliably stop corrosion toward the second electrode function portion and to prevent infiltration of moisture into the second electrode function portion.

The second electrode layer forming step may include: a step of forming a first layer containing at least one of an alkali metal, an alkali earth metal, an alkali metal compound, and an alkali earth metal compound; and a step of forming a second layer containing an amphoteric metal on the first layer. When the first layer reacts with moisture, the second layer corrodes accordingly. Therefore, the method for manufacturing the organic electronic device is further effective for the case where the second electrode layer including the first and second layers is formed.

In the hole forming step, the hole may be formed outwards in the first direction from the organic functional layer.

In the hole forming step, the hole may be formed in such a way as to be located on the organic functional layer and located outwards from the function exhibiting region in the first direction. In this case, the hole may be formed in such a way as to extend to an inside of the organic functional layer.

The method may further include a dicing step of individually dicing the flexible substrate obtained through the sealing step for each of the device formation regions. Thereby, the organic electronic devices separated from each other can be obtained.

According to another aspect of the present invention, an organic electronic device includes: a flexible substrate including a first end and a second end located on a side opposite to the first end in a first direction; a first electrode layer provided on the flexible substrate; an organic functional layer provided on the first electrode layer; a second electrode layer provided from the first end to the second end and covering at least a part of the organic functional layer; and a sealing member provided on the second electrode layer and sealing the organic functional layer, at least a part of the second electrode layer on the organic functional layer is a second electrode function portion, a hole is formed in the second electrode layer at an outside of the second electrode function portion and both sides of the second electrode function portion in the first direction, the hole extending through the second electrode layer in a second direction crossing the first direction, and the sealing member is provided on the second electrode layer such that a part of the first electrode layer is exposed from an end of the sealing member in the second direction, and covers a surface of the hole on a side of the second electrode function portion.

In the organic electronic device, since the second electrode layer is provided from the first end to the second end of the flexible substrate in the first direction, the second electrode layer is easily formed in the first direction and productivity is improved at the time of manufacturing the organic electronic device. In the configuration of the second electrode layer, both ends in the first direction of the second electrode layer are exposed. As described above, even when the both ends of the second electrode layer are exposed, since the hole is formed in the second electrode layer at the outside of the second electrode function portion in the first direction in the organic electronic device, the progress of corrosion is stopped by the hole even when corrosion occurs at the both ends of the second electrode layer due to moisture, thereby the corrosion does not reach the second electrode function portion. Further, since the surface of the hole on the side of the second electrode function portion is covered with the sealing member, infiltration of moisture from the surface to the second electrode layer is also prevented. Therefore, since the second electrode function portion can maintain the function thereof, performance deterioration of the organic electronic device can also be prevented.

The hole may be formed outwards in the first direction from the organic functional layer. The hole may extend into the organic functional layer. A part of the sealing member may be filled in the hole.

### Advantageous Effects of Invention

According to the present invention, it is possible to provide a method for manufacturing an organic electronic device capable of improving productivity and preventing performance deterioration and an organic electronic device.

### Brief Description of Drawings

[Fig. 1] Fig. 1 is a plan view of a long flexible substrate used in a method for manufacturing an organic EL device (an organic electronic device) according to an embodiment.
[Fig. 2] Fig. 2 is a conceptual diagram of a method for manufacturing an organic EL device by using a roll-to-roll method.
[Fig. 3] Fig. 3 is a view for describing an anode layer (first electrode layer) forming step.
[Fig. 4] Fig. 4 is a view for describing an organic functional layer forming step.
[Fig. 5] Fig. 5 is a view for describing an electrode layer (second electrode layer) forming step.
[Fig. 6] Fig. 6 is a cross-sectional view taken along line VI-VI in Fig. 5.
[Fig. 7] Fig. 7 is a view for describing a hole forming step.
[Fig. 8] Fig. 8 is a view for describing a sealing step.
[Fig. 9] Fig. 9 is a cross-sectional view for describing an example of a configuration of an individually diced organic electronic device.
[Fig. 10] Fig. 10 is a cross-sectional view taken along line X-X in Fig. 9.
[Fig. 11] Fig. 11 is a view for describing a modification of the hole forming step.
[Fig. 12] Fig. 12 is a view for describing another modification of the hole forming step.
[Fig. 13] Fig. 13 is a view for describing further another modification of the hole forming step.
[Fig. 14] Fig. 14 is a view for describing still further another modification of the hole forming step.

### Description of Embodiments

An embodiment of the present invention will be described below with reference to the drawings. The same components are denoted by the same reference numerals, and the repeated description will not be presented. Dimensional ratios in the drawings are not necessarily consistent with their descriptions. Examples of the organic electronic device include an organic EL device, an organic solar cell, an organic photodetector, and an organic sensor. In the embodiment described below, unless otherwise noted, the organic electronic device is a bottom emission type organic EL device. However, the organic electronic device may be a top emission type organic EL device.

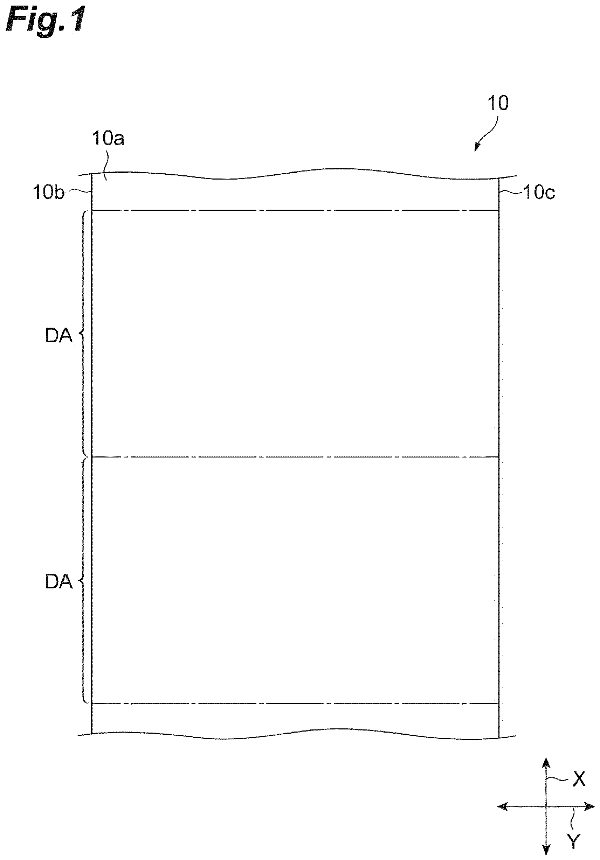

Fig. 1 is a plan view of a long flexible substrate 10 used in a method for manufacturing an organic EL device according to an embodiment. In the present description, the long flexible substrate 10 indicates a substrate that extends in one direction and has flexibility, the extending direction (longitudinal direction) having a length longer than a length in a direction (width direction) orthogonal to the extending direction. The flexibility is a property that enables the substrate to be bent without shearing or breaking even when a predetermined force is applied to the substrate. For convenience of description, the longitudinal direction of the flexible substrate 10 is also referred to as an X-direction (first direction), and the direction orthogonal to the longitudinal direction is also referred to as a Y-direction (second direction).

The flexible substrate 10 has a property of transmitting visible light (light with a wavelength of 400 nm to 800 nm). A thickness of the flexible substrate 10 is, for example, 30 µm or more and 500 µm or less. The flexible substrate 10 may have a film shape.

The flexible substrate 10 is, for example, a plastic film. Examples of the material for the flexible substrate 10 include polyethersulfone (PES); a polyester resin such as polyethylene terephthalate (PET) or polyethylene naphthalate (PEN); a polyolefin resin such as polyethylene (PE), polypropylene (PP), or cyclic polyolefin; a polyamide resin; a polycarbonate resin; a polystyrene resin; a polyvinyl alcohol resin; a saponified ethylene-vinyl acetate copolymer; polyacrylonitrile resin; an acetal resin; a polyimide resin; and an epoxy resin.

From the above resins, in view of high heat resistance, low linear expansion coefficient, and low production cost, the polyester resin or the polyolefin resin is preferable as the material for the flexible substrate 10, and the polyethylene terephthalate or the polyethylene naphthalate is more preferable. One of these resins may be used alone, or two or more thereof may be used in combination.

A barrier layer (particularly, a barrier layer for blocking moisture) may be disposed on a surface 10a of the flexible substrate 10 to block gas, moisture, and the like.

In the manufacture of the organic EL device, a plurality of device formation regions DA are virtually set in the longitudinal direction of the long flexible substrate 10, and components of the organic EL device are formed on each of the device formation regions DA. In a case where the barrier layer is formed on the flexible substrate 10, the components of the organic EL device are formed on the barrier layer. Fig. 1 illustrates a plurality of device formation regions DA set to be in contact with each other in the X-direction. Each of the device formation regions DA includes a boundary. The boundary is an outer edge of the device formation region DA. In the case of Fig. 1, the boundary of the device formation region DA in the X-direction is also a boundary between two adjacent device formation regions DA. The plurality of device formation regions DA may be set discretely from each other. When the plurality of device formation regions DA are set discretely from each other, the boundary of the device formation region DA in the X-direction is a boundary between the device formation region DA and an outer region thereof.

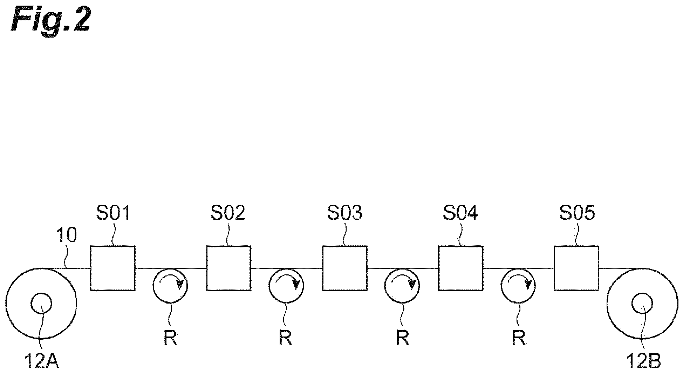

Fig. 2 shows a method for manufacturing the organic EL device according to an embodiment, and is a conceptual diagram of a method for manufacturing the organic EL device using a roll-to-roll method. When the organic EL device is manufactured by the roll-to-roll method, the roll-shaped flexible substrate 10 is set on a feeding portion 12A, the flexible substrate 10 is fed, the flexible substrate 10 is subjected to an anode layer (first electrode layer) forming step S01, an organic functional layer forming step S02, an electrode layer (second electrode layer) forming step S03, a hole forming step S04, and a sealing step S05 in this order while being conveyed toward a winding portion 12B with a conveyance roll R, and then the flexible substrate 10 is wound in a roll shape by the winding portion 12B.

The feeding portion 12A, the winding portion 12B, and the conveyance roll R form a part of a conveyance mechanism of the flexible substrate 10. The conveyance mechanism may include other known components such as a tension adjusting mechanism. A desired tension may be applied to the flexible substrate 10, which is conveyed by the roll-to-roll method, in a longitudinal direction within a range in which the flexible substrate 10 does not sag or break. A winding step or an unwinding step may be provided between the respective steps. Further, after the respective steps, the flexible substrate 10 may be once wound up and held, and then, the flexible substrate 10 may be subjected to the subsequent step after being unwound again.

### [Anode layer forming step]

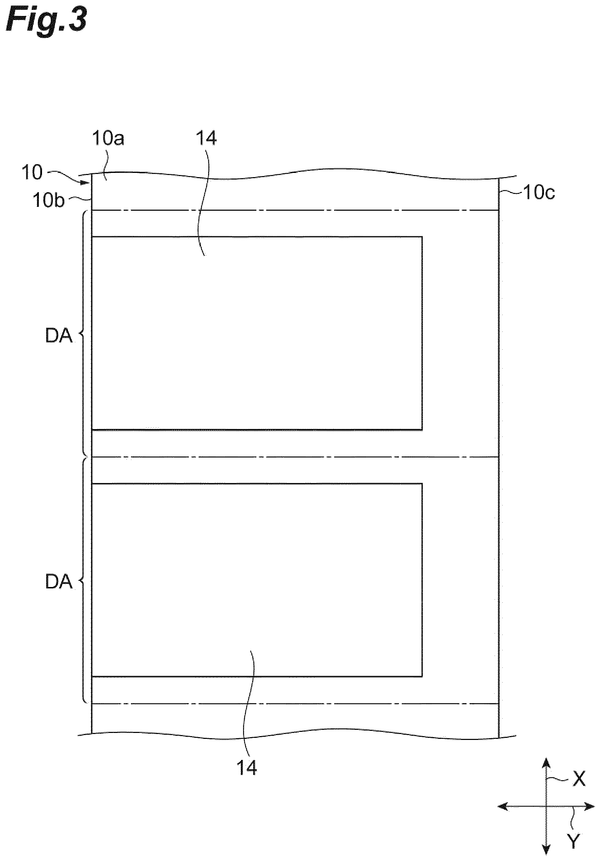

In the anode layer forming step S01, as shown in Fig. 3, an anode layer 14 is formed in each of a plurality of device formation regions DA virtually set in the X-direction of the flexible substrate 10.

An electrode exhibiting light transmittance is used for the anode layer 14. As the electrode exhibiting light transmittance, a thin film containing a metal oxide, a metal sulfide, or a metal having high electrical conductivity can be used. A thin film having high light transmittance is preferable to be used as the anode layer 14. The anode layer 14 may have a network structure consisting of a conductor (for example, a metal). A thickness of the anode layer 14 can be determined in consideration of light transmittance, electric conductivity, and the like. The thickness of the anode layer 14 is generally 10 nm to 10 µm, preferably 20 nm to 1 µm, and more preferably 50 nm to 500 nm.

Examples of a material for the anode layer 14 include indium oxide, zinc oxide, tin oxide, indium tin oxide (abbreviation ITO), indium zinc oxide (abbreviation IZO), gold, platinum, silver, and copper. Among these, ITO, IZO, or tin oxide is preferable. The anode layer 14 can be formed in the form of a thin film consisting of the materials described above. The material of the anode layer 14 may include organic materials such as polyaniline and derivatives thereof and polythiophene and derivatives thereof. In this case, the anode layer 14 can be formed as a transparent conductive film.

The anode layer 14 can be formed by a dry film-formation method, a plating method, and a coating method. Examples of the dry film-formation method may include a vacuum deposition method, a sputtering method, an ion plating method, and a CVD method. Examples of the coating method include an inkjet printing method, a slit coating method, a microgravure coating method, a gravure coating method, a bar coating method, a roll coating method, a wire bar coating method, a spray coating method, a screen printing method, a flexography printing method, an offset printing method, and a nozzle printing method.

### [Organic functional layer forming step]

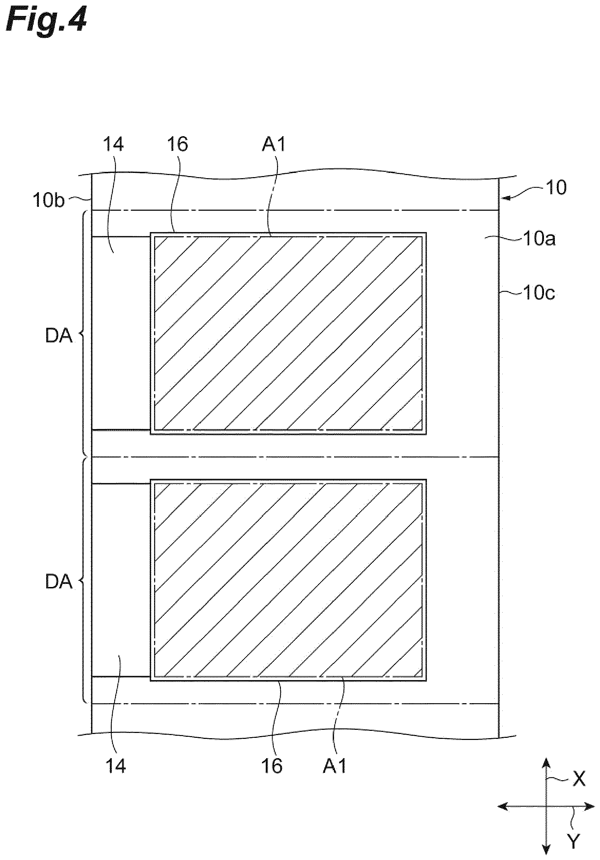

In the organic functional layer forming step S02, as shown in Fig. 4, an organic functional layer 16 is formed on the anode layer 14. The organic functional layer 16 is formed on the anode layer 14 in such a way as to expose a part of the anode layer 14 (an end on a side of an edge 10b of the flexible substrate 10 in the example shown in Fig. 4). In the organic EL device, a region between the anode layer 14 and a cathode function portion 24 of an electrode layer 20 to be described below in the organic functional layer 16 is a function exhibiting region (a light emitting region) for emitting light. A hatching in Fig. 4 indicates a function exhibiting design region A1 to be a function exhibiting region in the organic functional layer 16. As shown in Fig. 4, the function exhibiting design region A1 has a one-to-one correspondence with the device formation region DA.

The light emitting layer is a functional layer having a function of emitting light (including visible light). In general, the light emitting layer contains an organic substance emitting mainly at least one of fluorescence and phosphorescence, or the organic substance and a dopant material that aids the organic substance. Therefore, the light emitting layer is an organic layer. The dopant material is added, for example, to improve a light-emitting efficiency or to change a light-emitting wavelength. The organic substance may be a low molecular compound or a high molecular compound. The thickness of the light emitting layer is, for example, 2 nm to 200 nm.

Examples of the organic substance emitting mainly at least one of fluorescence and phosphorescence include dye-based materials, metal complex-based materials, and polymer-based materials.

### (Dye-based material)

Examples of the dye-based material include cyclopentamine derivatives, tetraphenyl butadiene derivative compounds, triphenylamine derivatives, oxadiazole derivatives, pyrazoloquinoline derivatives, distyrylbenzene derivatives, distyryl arylene derivatives, pyrrole derivatives, thiophene ring compounds, pyridine ring compounds, perinone derivatives, perylene derivatives, oligothiophene derivatives, oxadiazole dimers, pyrazoline dimers, quinacridone derivatives, and coumarin derivatives.

### (Metal complex-based material)

Examples of the metal complex-based material include metal complexes which contain a rare earth metal such as Tb, Eu or Dy, or Al, Zn, Be, Ir or Pt as a central metal and have oxadiazole, thiadiazole, phenylpyridine, phenylbenzimidazole, or quinoline structure as a ligand. Examples of the metal complexes include metal complexes emitting light from a triplet excited state such as iridium complexes and platinum complexes, aluminum quinolinol complexes, benzoquinolinol beryllium complexes, benzoxazolyl zinc complexes, benzothiazole zinc complexes, azomethyl zinc complexes, porphyrin zinc complexes, and phenanthroline europium complexes.

### (Polymer-based material)

Examples of the polymer-based material include polyparaphenylene vinylene derivatives, polythiophene derivatives, polyparaphenylene derivatives, polysilane derivatives, polyacetylene derivatives, polyfluorene derivatives, polyvinylcarbazole derivatives, and materials in which the dye-based materials or the metal complex-based materials are polymerized.

### (Dopant material)

Examples of the dopant material include perylene derivatives, coumarin derivatives, rubrene derivatives, quinacridone derivatives, squarylium derivatives, porphyrin derivatives, styryl dyes, tetracene derivatives, pyrazolone derivatives, decacyclene, and phenoxazone.

The light emitting layer is formed by a method similar to the method described for the anode layer. When the light emitting layer is formed while the flexible substrate 10 is conveyed, it is preferable to use a coating method, in particular, an inkjet printing method in order to improve productivity.

The structure of the organic functional layer 16 may be a single-layer structure or a multilayer structure including various functional layers in addition to the light emitting layer. Examples of the layer configuration of the organic functional layer are as follows. In the following examples of the layer configuration, the anode layer is also described in parentheses in such a way to indicate an arrangement relation with the anode layer 14.
(a) (anode layer)/light emitting layer
(b) (anode layer)/hole injection layer/light emitting layer
(c) (anode layer)/hole injection layer/light emitting layer/electron injection layer
(d) (anode layer)/hole injection layer/light emitting layer/electron transport layer/electron injection layer
(e) (anode layer)/hole injection layer/hole transport layer/light emitting layer
(f) (anode layer)/hole injection layer/hole transport layer/light emitting layer/electron injection layer
(g) (anode layer)/hole injection layer/hole transport layer/light emitting layer/electron transport layer/electron injection layer
(h) (anode layer)/light emitting layer/electron injection layer
(i) (anode layer)/light emitting layer/electron transport layer/electron injection layer.

The symbol "/" means that the layers on both sides of the symbol "/" are joined. The above configuration example (a) is an example in a case where the structure of the organic functional layer 16 is a single-layer structure.

A known material can be used as a material for the functional layers (for example, a hole transport layer and an electron transport layer) other than the light emitting layer included in the organic functional layer 16. The functional layers included in the organic functional layer 16 have different optimal thickness values depending on the material to be used. The thickness of the functional layer included in the organic functional layer 16 is set in consideration of electric conductivity, durability and the like. A method for forming the functional layers other than the light emitting layer included in the organic functional layer 16 is the same as that for the light emitting layer.

### [Electrode layer forming step]

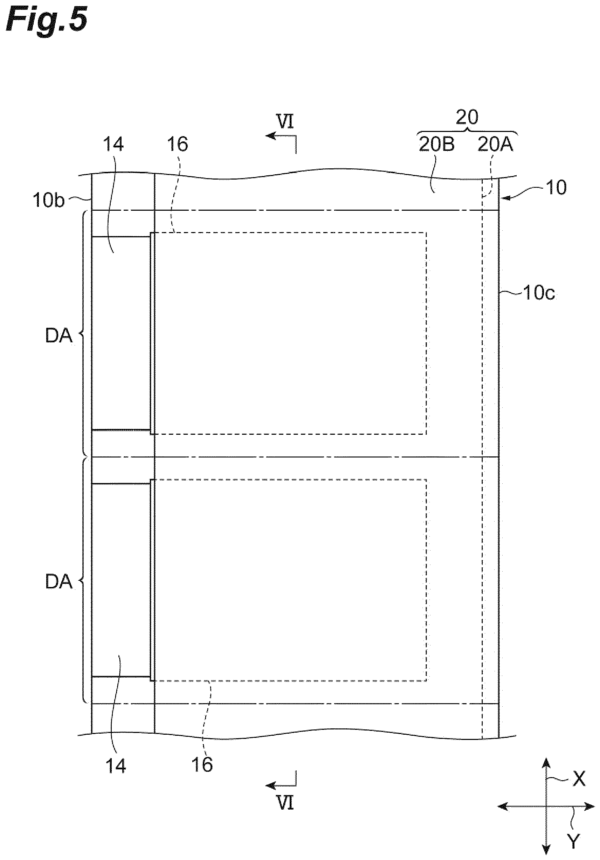

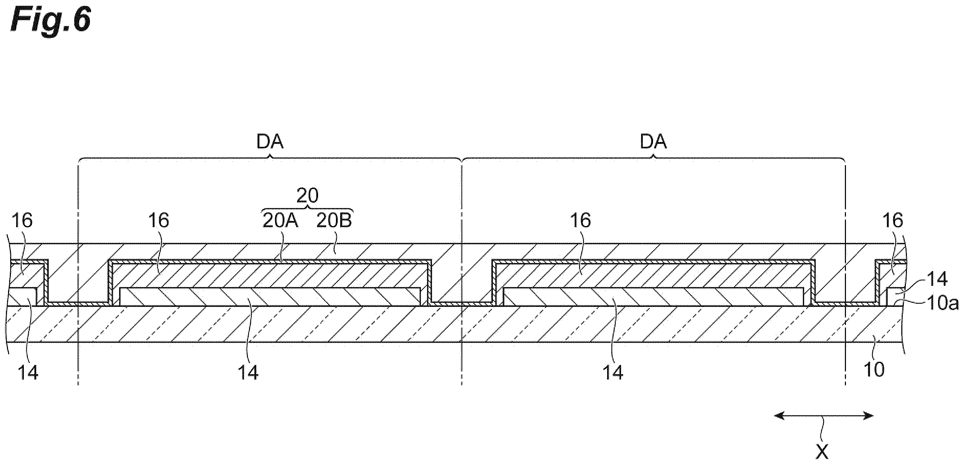

In the electrode layer forming step S03, as shown in Figs. 5 and 6, an electrode layer 20 is formed on the flexible substrate 10 and the organic functional layer 16. Specifically, the electrode layer 20 is formed on the flexible substrate 10 and the organic functional layer 16 over the plurality of device formation regions DA in such a way as to cover at least a part of the respective organic functional layers 16 in a state of being insulated from the respective anode layers 14 in the X-direction. In the present embodiment, the electrode layer 20 is formed such that the electrode layer 20 is in contact with the surface 10a of the flexible substrate 10 on the edge 10c side of the flexible substrate 10.

The electrode layer 20 includes a first layer (a lower layer) 20A containing at least one of an alkali metal, an alkali earth metal, an alkali metal compound and an alkali earth metal compound, and a second layer (an upper layer) 20B containing an amphoteric metal. The electrode layer forming step S03 includes a lower layer forming step of forming the lower layer 20A and an upper layer forming step of forming the upper layer 20B on the lower layer 20A.

In the lower layer forming step, a lower layer 20A is formed on the flexible substrate 10 over the plurality of device formation regions DA in such a way as to cover the respective organic functional layers 16 in a state of being insulated from the respective anode layers 14. In the present embodiment, the lower layer 20A is formed in such a way as to be in contact with the surface 10a of the flexible substrate 10 on the edge 10c side of the flexible substrate 10. The lower layer 20A can be formed by dry film-formation method such as a vacuum deposition method, a sputtering method, or an ion plating method. The lower layer 20A may be formed by a coating method.

A material for the lower layer 20A includes at least one of an alkali metal, an alkali earth metal, an alkali metal compound, and an alkali earth metal compound. The alkali metal compound and the alkali earth metal compound are a compound containing an alkali metal element and a compound containing an alkali earth metal element, respectively, and include alkali metal fluoride, alkali earth metal fluoride, alkali metal oxide, and alkali earth metal oxide, for example. Specifically, the material for the lower layer 20A is sodium (Na), cesium (Cs), lithium (Li), sodium fluoride (NaF), lithium fluoride (LiF), calcium fluoride (CaF), or barium oxide (BaO). An example of a thickness of the lower layer 20A is 0.2 nm to 20 nm, and is preferable to be 1 nm to 5 nm from the viewpoint of conductivity control.

In the upper layer forming step, an upper layer 20B is formed on the lower layer 20A over the plurality of device formation regions DA. In the present embodiment, the upper layer 20B is formed such that one end of the upper layer 20B in the Y-direction (an end on the side of the edge 10b of the flexible substrate 10) coincides with a corresponding one end of the lower layer 20A and the other end of the upper layer 20B (an end on the side of the edge 10c of the flexible substrate 10) covers the corresponding other end of the lower layer 20A. The upper layer 20B may be formed such that one end of the upper layer 20B in the Y-direction (the end on the side of the edge 10b of the flexible substrate 10) covers a corresponding one end of the lower layer 20A and the other end of the upper layer 20B (the end on the side of the edge 10c of the flexible substrate 10) coincides with a corresponding one end of the lower layer 20A. The upper layer 20B can be formed by a dry film-formation method such as a vacuum deposition method, a sputtering method, or an ion plating method. The upper layer 20B may be formed by a coating method.

A material for the upper layer 20B includes amphoteric metals that react with an alkaline aqueous solution. Examples of amphoteric metals include aluminum (Al), zinc (Zn), and tin (Sb). As the material for the upper layer 20B, a material hardly affected by moisture and a metal (for example, aluminum) having high reflectivity against visible light are more preferable. An example of a thickness of the upper layer 20B is 30 nm to 5000 nm, and is preferable to be 80 nm to 300 nm and more preferable to be 90 nm to 200 nm from the viewpoint of light reflection and productivity.

### [Hole forming step]

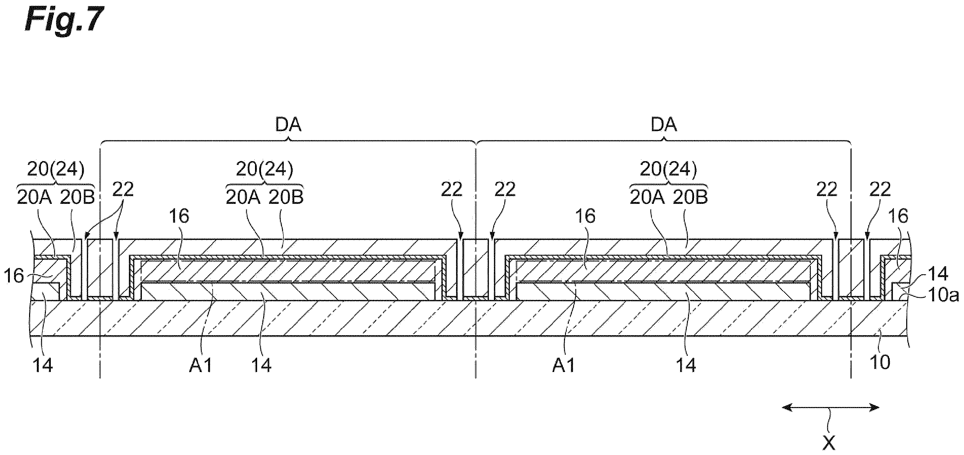

In the hole forming step S04, as shown in Fig. 7, the electrode layer 20 between the boundary (the outer edge of the device formation region DA) of the device formation region DA and the function exhibiting design region A1 of the organic functional layer 16 in the X-direction is removed from one end to the other end of the electrode layer 20 in the Y-direction, and thus a hole 22 is formed. At the time of forming the hole 22, the electrode layer 20 is removed across both surfaces of the electrode layer 20 in the thickness direction of the electrode layer 20. In other words, the hole 22 is formed in such a way as to penetrate the electrode layer 20 in the thickness direction. In each of the device formation regions DA, thus, the holes 22 are formed on both sides of the function exhibiting design region A1 in the X-direction.

The hole 22 can be formed, for example, in such a manner that a laser beam is irradiated onto the electrode layer 20 from a laser beam source provided on the conveyance path of the flexible substrate 10 and the electrode layer 20 in the irradiation region of the laser beam is removed. A wavelength of the laser beam may be a wavelength that can remove the electrode layer 20 (specifically, the upper layer 20B and the lower layer 20A). A method for forming the hole 22 is not limited to the method using the laser beam.

In the electrode layer 20 in which the hole 22 is formed, a portion between the pair of holes 22 on each of the device formation regions DA is a cathode function portion 24 functioning as a cathode in the organic EL device. In other words, the electrode layer 20 is separated into the cathode function portion (the second electrode mechanism portion) 24 and other portions by the formation of the hole 22 in the hole forming step S04. As a result, the cathode function portion 24 is obtained in the hole forming step S04.

### [Sealing step]

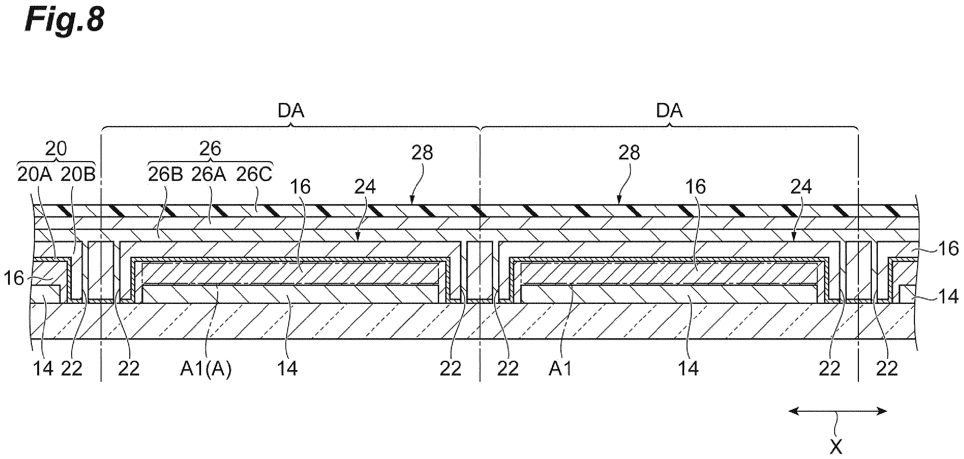

In the sealing step S05, as shown in Fig. 8, a sealing member 26 is provided on the electrode layer 20 in which the hole 22 is formed, thereby sealing the organic functional layer 16. In the sealing step S05, more specifically, the sealing member 26 is provided on the electrode layer 20 such that a part of the anode layer 14 is exposed from the sealing member 26 on the side of the edge 10b (see Figs. 1, 4, and 5) of the flexible substrate 10, a part of the electrode layer 20 is exposed from the sealing member 26 on the side of the edge 10c (see Figs. 1, 4, and 5) of the flexible substrate 10, and the surface of the hole 22 on the side of the function exhibiting design region A1 is covered. The sealing member 26 is a member for preventing deterioration of the organic EL device due to moisture. The sealing member 26 includes a sealing base 26A, an adhesive layer 26B, and a resin film 26C.

The sealing base 26A has a moisture barrier function. The sealing base 26A may have a gas barrier function. Examples of the sealing base 26A are a metal foil, a barrier film having a barrier functional layer formed on one surface or both surfaces of a transparent plastic film, a thin film glass having flexibility, and a film in which metal having a barrier property is laminated on a plastic film. An example of a thickness of the sealing base 26A is 10 µm to 300 µm. As the metal foil, a copper foil, an aluminum foil, or a stainless-steel foil is preferable from the viewpoint of a barrier property. When the sealing base 26A is the metal foil, a thickness of the metal foil is preferably as large as possible from the viewpoint of suppressing a pinhole, and is preferable to be 10 µm to 50 µm from the viewpoint of flexibility.

The adhesive layer 26B is laminated on one surface of the sealing base 26A. The adhesive layer 26B may have a thickness capable of burying a portion to be sealed with the sealing member 26 in the organic EL device. An example of the thickness of the adhesive layer 26B is 5 µm to 100 µm.

Examples of a material of the adhesive layer 26B include a photocurable or thermosetting acrylate resin and a photocurable or thermosetting epoxy resin. Other resin films which can be fused by a generally used impulse sealer, for example, a heat-fusible film such as an ethylene vinyl acetate copolymer (EVA), a polypropylene (PP) film, a polyethylene (PE) film, and a polybutadiene film, can be used as the adhesive layer 26B. A thermoplastic resin can also be used for the material for the adhesive layer 26B, and examples thereof include an olefin-based elastomer, a styrene-based elastomer, and a butadiene-based elastomer.

The adhesive layer 26B may include a moisture absorbing fine particles (smaller than the thickness of the adhesive layer 26B). Examples of the moisture absorbing fine particles include metal oxides that cause a chemical reaction with moisture at room temperature and zeolites that physically adsorb moisture.

The resin film 26C is laminated on the other surface (the surface opposite to the surface in contact with the adhesive layer 26B) of the sealing base 26A. Examples of a material for the resin film 26C include polyethylene terephthalate (PET) and polyimide (PI).

In the sealing step S05, the long sealing member 26 is bonded to the conveyed flexible substrate 10 while being conveyed in the longitudinal direction. Specifically, the long sealing member 26 is positioned on the flexible substrate 10 such that the adhesive layer 26B faces the electrode layer 20 and the anode layer 14 and the electrode layer 20 are partially exposed in the Y-direction when viewed in the thickness direction of the sealing member 26. In this state, the sealing member 26 and the flexible substrate 10 are pressurized and heated in the thickness direction of the sealing member 26, and thus the sealing member 26 is bonded to the flexible substrate 10, thereby sealing the organic functional layer 16. In such a sealing step S05, as shown in Fig. 8, the hole 22 is filled with the adhesive layer 26B, and the surface of the hole 22 on the side of the function exhibiting design region A1 is covered.

Fig. 8 illustrates the sealing member 26 including the resin film 26C, but it is enough that the sealing member 26 includes the sealing base 26A and the adhesive layer 26B.

Through the sealing step S05, as shown in Fig. 8, an organic EL device 28 is obtained for each of the device formation regions DA. Therefore, it is possible to obtain the organic EL device 28 individually diced by a dicing step of dicing the flexible substrate 10 obtained through the sealing step S05 for each of the device formation regions DA. Normally, since the device formation region DA is set to a product size, the organic EL device 28 having the product size can be obtained in the case including the dicing step. In the dicing step, for example, the flexible substrate 10 may be cut using the boundary (outer edge) of the respective device formation region DA as a cutting line while the flexible substrate 10 obtained through the sealing step S05 is conveyed. Hereinafter, for convenience of description, the organic EL device 28 having the product size is referred to as an organic EL device 28A.

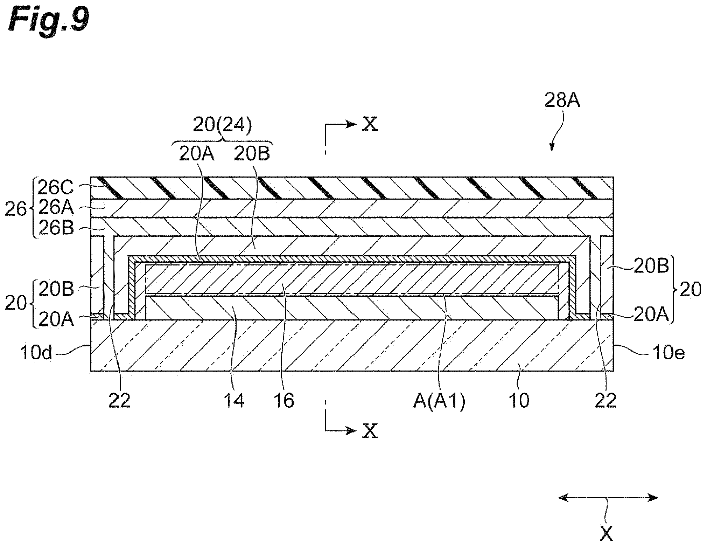

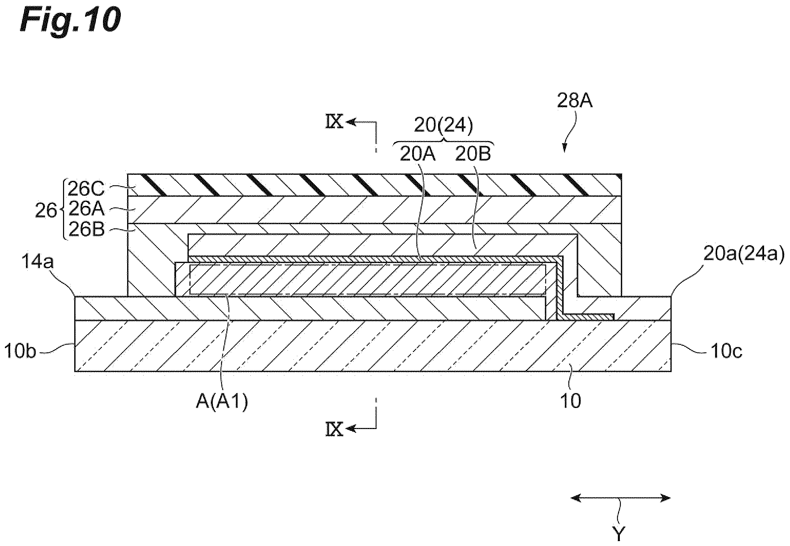

Fig. 9 is a cross-sectional view schematically showing a configuration of the organic EL device obtained through the dicing step. Fig. 9 corresponds to a cross-sectional view taken along line IX-IX in Fig. 10. Fig. 10 is a cross-sectional view taken along line X-X in Fig. 9. An X-direction and a Y-direction in Figs. 9 and 10 are the same as the X-direction and the Y-direction used in the description of the manufacturing method.

The organic EL device 28A includes a flexible substrate 10, and an anode layer (a first electrode layer) 14, an organic functional layer 16, an electrode layer (a second electrode layer) 20 and a sealing member 26 which are provided in this order on the flexible substrate 10. The electrode layer 20 includes a cathode function portion 24. Since the configurations of the flexible substrate 10, the anode layer 14, the organic functional layer 16, the electrode layer 20, and the sealing member 26 are described in the description of the method for manufacturing the organic EL device, the description thereof will not be presented as appropriate, and the organic EL device 28A will be described.

As shown in Fig. 9, the flexible substrate 10 included in the organic EL device 28A includes, in the X-direction, an end (a first end) 10d and an end (a second end) 10e located on the opposite side to the end 10d. Both ends of the electrode layer 20 and the sealing member 26 in the X-direction are exposed.

The electrode layer 20 includes the cathode function portion 24, and a pair of holes 22 extending in the Y-direction are formed outside the cathode function portion 24 and on both sides of the cathode function portion 24 in the X-direction. Thus, the cathode function portion 24 and the remaining portion (a portion located outwards from the hole 22 in the X-direction) of the electrode layer 20 are separated from each other by the hole 22. The surface of the hole 22 on the side of the cathode function portion 24 is covered with the sealing member 26. As shown in Fig. 9, the electrode layer 20 (specifically, the remaining portion of the electrode layer 20) exists on the end (first end) 10d and the end (second end) 10e of the flexible substrate 10.

As shown in Fig. 10, an end 14a of the anode layer 14 and an end 20a of the electrode layer 20 are exposed on sides opposite from the sealing member 26 in the Y-direction. The region of the anode layer 14 exposed from the sealing member 26 corresponds to a terminal portion for external connection of the anode layer 14. Since the end 20a of the electrode layer 20 is exposed from the sealing member 26, the corresponding end 24a of the cathode function portion 24 is also exposed. The region of the cathode function portion 24 exposed from the sealing member 26 corresponds to a terminal portion for external connection of the cathode function portion 24.

In the organic EL device 28A, a voltage is applied to the anode layer 14 and the cathode function portion 24 via the terminal portions (the regions exposed from the sealing member 26) of the anode layer 14 and the cathode function portion 24. Therefore, light is emitted in the function exhibiting region A (the function exhibiting design region A1), which is a region sandwiched between the anode layer 14 and the cathode function portion 24 in the thickness direction of the flexible substrate 10, of the organic functional layer 16. As shown in Figs. 9 and 10, the flexible substrate 10 included in the organic EL device 28A and the function exhibiting region A have a one-to-one correspondence with each other.

In the method for manufacturing the organic EL device, since the electrode layer 20 is formed in a stripe shape over the plurality of device formation regions DA, the electrode layer 20 can be efficiently formed while the flexible substrate 10 is conveyed by the roll-to-roll method. For example, the electrode layer 20 can be formed continuously while the flexible substrate 10 is conveyed by the roll-to-roll method. As a result, the productivity of the organic EL device 28 is improved. For example, when the electrode layer 20 is formed by the dry film-formation method, the electrode layer 20 can be formed continuously as described above by shielding the vicinity of the edge 10b and the edge 10c of the flexible substrate 10 with a mask extending in the X-direction. Therefore, for example, a shielding mask is easily formed compared with a case of forming a mask to form a shielding region also in the Y-direction.

In the individual organic EL device 28A obtained by dicing the flexible substrate 10 in the device formation region DA, as shown in Fig. 9, the both ends of the electrode layer 20 in the X-direction are exposed without being sealed with the sealing member 26. Therefore, the electrode layer 20 may be corroded by moisture. In particular, when the electrode layer 20 has a configuration including the lower layer 20A and the upper layer 20B having the materials described above, the lower layer 20A easily reacts with moisture, the upper layer 20B is melted by a basic substance (an alkali substance) generated due to the reaction of the lower layer 20A with the moisture, and corrosion of the upper layer 20B progresses.

If the hole 22 is not formed in the electrode layer 20, the corrosion from the exposed both ends of the electrode layer 20 reaches the cathode function portion 24, and the function of the cathode function portion 24 as a cathode is impaired. As a result, the performance of the organic EL device deteriorates, and no light emission occurs in some cases.

In the method for manufacturing the organic EL device of the present embodiment, the hole forming step S04 is provided subsequent to the electrode layer forming step S03, and the hole 22 is formed in the electrode layer 20. The cathode function portion 24 is separated, by the hole 22, from the portion of the electrode layer 20 located outwards from the hole 22 in the X-direction. Therefore, as described above, even when the corrosion progresses from the both ends in the X-direction of the electrode layer 20 due to moisture, the progress of the corrosion is stopped by the hole 22, and thus the corrosion of the cathode function portion 24 can be prevented. Further, since the surface of the hole 22 on the side of the function exhibiting design region A1 is covered with the sealing member 26, even when the electrode layer 20 is separated by the hole 22, infiltration of moisture from the hole 22 into the electrode layer 20 can also be prevented. As a result, performance deterioration of the organic EL device 28A can be prevented.

In the organic EL device 28A, a part of the cathode function portion 24 is exposed from the sealing member 26 as a terminal portion for external connection in the Y-direction. However, as shown in Fig. 10, the end of the lower layer 20A in contact with the flexible substrate 10 is covered with the upper layer 20B. Then, since the upper layer 20B itself is hardly corroded by moisture, corrosion of the terminal portion of the cathode function portion 24 and corrosion of the cathode function portion 24 accompanying the corrosion of the terminal portion are also prevented. As shown in Fig. 10, in the case where the end of the lower layer 20A is located inward from the end of the sealing member 26, even when a pinhole is present in the exposed upper layer 20B and moisture infiltrates from the pinhole, corrosion of the upper layer 20B can be prevented.

In the case where the electrode layer 20 includes the lower layer 20A and the upper layer 20B having the materials described above, the lower layer 20A easily reacts with moisture. When the lower layer 20A reacts with the moisture, the upper layer 20B corrodes accordingly. Therefore, the method for manufacturing the organic electronic device is effective for the case where the electrode layer 20 includes the lower layer 20A and the upper layer 20B described above.

In the case where the hole 22 is filled with a part of the sealing member 26, the corrosion from the both ends of the electrode layer 20 in the X-direction can be more reliably stopped at the position of the hole 22, and the infiltration of moisture from the hole 22 into the cathode function portion 24 can be prevented.

Various embodiments of the present invention have been described above. However, the present invention is not limited to the various embodiments. The present invention is intended to cover the scope defined by claims, and to include meanings equivalent to claims and all modifications as would fall within the scope of the present invention.

For example, the case where the hole 22 is formed, in the hole forming step S04, at the position of the electrode layer 20 located outwards from the organic functional layer 16 between the boundary of the device formation region DA and the function exhibiting design region A1 in the X-direction is described. However, as long as a desired light emitting region (function exhibiting region) can be secured, the hole 22 may be formed on the organic functional layer 16, or the hole 22 may be formed on the boundary (in other words, across the boundary) between the function exhibiting design regions A1 adjacent to each other in the X-direction.

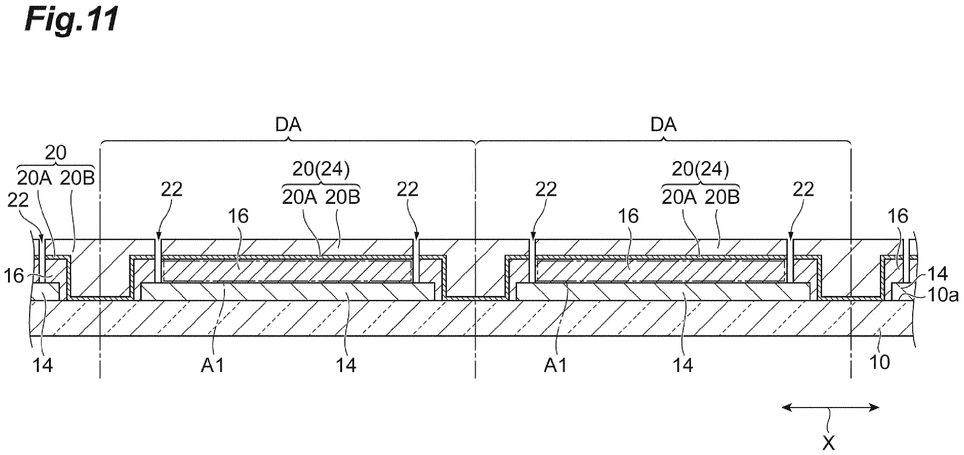

Fig. 11 is a diagram showing an example of a case in which the hole 22 is formed on the organic functional layer 16, located outwards from the function exhibiting design region A1 in the X-direction. In this case, the hole 22 is preferable to be formed near the end of the organic functional layer 16 in the X-direction in order to secure the function exhibiting design region A1 wider. In the example shown in Fig. 11, the hole 22 extends to the inside of the organic functional layer 16. Specifically, the hole 22 also penetrates the organic functional layer 16. In this case, an organic EL device having the same configuration as the organic EL device 28 (28A) is manufactured except that the position of the hole 22 is different. In the electrode layer 20, a region between the two holes 22 in the X-direction is the cathode function portion 24. Since the cathode function portion 24 is separated, by the hole 22, from a portion of the electrode layer 20 located outwards from the hole 22, corrosion of the exposed end of the electrode layer 20 due to moisture does not reach the cathode function portion 24. Accordingly, a method for manufacturing the organic EL device including the hole forming step S04 of forming the hole 22 as shown in Fig. 11 and an organic EL device manufactured by such a method have the same operational effects as those of the method for manufacturing the organic EL device described in the above embodiment and the organic EL device manufactured by the method.

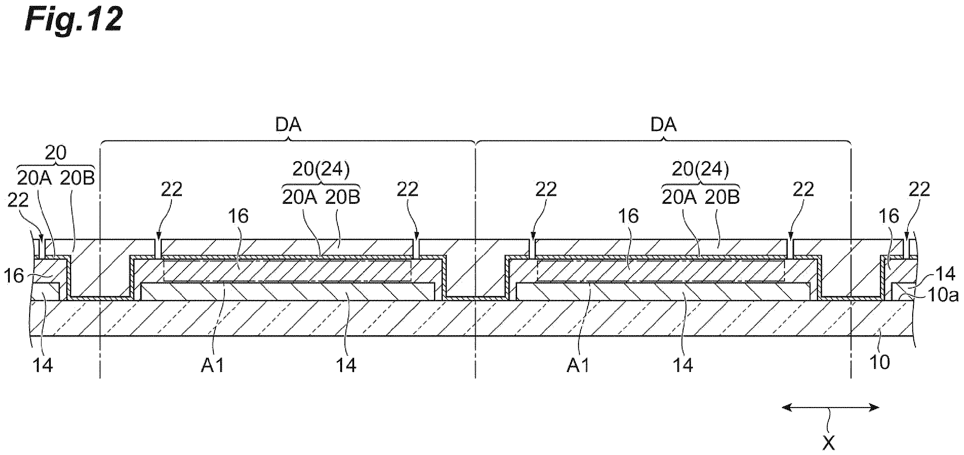

Fig. 12 shows another example of a case in which the hole 22 is formed on the organic functional layer 16, located outwards from the function exhibiting design region A1 in the X-direction. As shown in Fig. 12, the hole 22 may not extend into the organic functional layer 16. Also in this case, a method for manufacturing the organic EL device including the hole forming step S04 of forming the hole 22 as shown in Fig. 12 and an organic EL device manufactured by such a method have the same operational effects as those of the method for manufacturing the organic EL device described in the above embodiment and the organic EL device manufactured by the method.

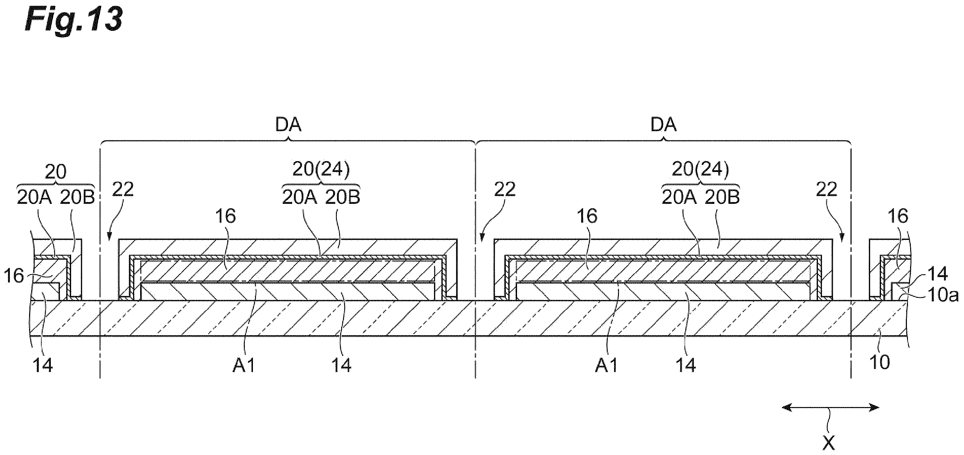

Fig. 13 is a diagram showing an example of a case in which the hole 22 is formed on the boundary of the device formation region DA in the X-direction. As shown in Fig. 13, a width of the hole 22 in the X-direction may be narrower than a width between the organic functional layers 16 adjacent to each other in the X-direction. In this case, both ends of the electrode layer 20 in the X-direction are sealed with the sealing member 26 through the sealing step S05. Thereby, corrosion itself of the both ends due to moisture can be prevented, and the cathode function portion 24 is also not corroded. Accordingly, a method for manufacturing the organic EL device including the hole forming step S04 of forming the hole 22 as shown in Fig. 13 and an organic EL device manufactured by such a method have the same operational effects as those of the method for manufacturing the organic EL device described in the above embodiment and the organic EL device manufactured by the method.

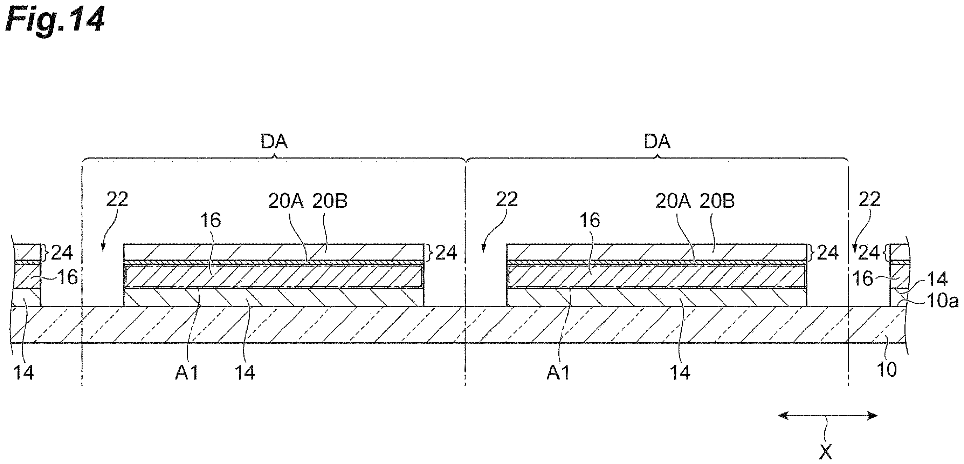

Fig. 14 is a diagram showing another example of a case in which the hole 22 is formed on the boundary of the device formation region DA in the X-direction. As shown in Fig. 14, a width of the hole 22 in the X-direction may be equal to a width between the anode layers 14 adjacent to each other in the X-direction. Also in this case, both ends of the electrode layer 20 in the X-direction are sealed with the sealing member 26 through the sealing step S05. Thereby, corrosion itself of the both ends due to moisture can be prevented, and the cathode function portion 24 is also not corroded. Accordingly, a method for manufacturing the organic EL device including the hole forming step S04 of forming the hole 22 as shown in Fig. 14 and an organic EL device manufactured by such a method have the same operational effects as those of the method for manufacturing the organic EL device described in the above embodiment and the organic EL device manufactured by the method.

As shown in Figs. 13 and 14, in the case in which the hole 22 is formed on the boundary of the device formation region DA in the X-direction, the width of the hole 22 may be wider than the width between the anode layers 14 adjacent to each other in the X-direction as long as a desired function exhibiting region A (function exhibiting design region A1) can be secured.

Each of the steps from the anode layer forming step S01 to the sealing step S05 may not be performed while conveying the flexible substrate 10 as in the roll-to-roll method. However, when the electrode layer forming step (the second electrode layer forming step) S03 is performed while conveying the flexible substrate 10, it is advantageous in terms of improving productivity, and in particular, the electrode layer forming step (the second electrode layer forming step) S03 and the hole forming step S04 are preferable to be performed by the roll-to-roll method. The anode layer forming step S01 is not necessary when the flexible substrate 10 on which the anode layer 14 is formed in advance is prepared.

A sealing film is formed on the electrode layer 20 in the sealing step S05, for example, and thus the organic functional layer 16 may be sealed. In this case, the sealing film corresponds to the sealing member, and the sealing film may be formed by, for example, a CVD method.

As long as the sealing member 26 covers the surface of the hole 22, which is formed in the electrode layer (the second electrode layer) 20, on the side of the function exhibiting design region A1, a part of the sealing member may not be filled in the hole 22. In other words, when the sealing member 26 is provided on the electrode layer 20 in such a way as to cover the surface of the hole 22 on the side of the function exhibiting design region A1 in each of the device formation regions DA, the entire hole 22 may not be covered with the sealing member 26.

The organic EL device may include an extraction electrode for cathode, which is electrically connected to the cathode function portion 24 and functions as an external connection terminal, on the flexible substrate 10. The extraction electrode for cathode is provided on the surface 10a of the flexible substrate 10 in a state of being separated from the anode layer 14, and a part of the extraction electrode for cathode is exposed from the sealing member 26 in such a way as to be externally connectable. The extraction electrode for cathode may have, for example, the same material as the anode layer 14. In the organic EL device including the extraction electrode for cathode, the electrode layer 20 is formed such that the electrode layer 20 is in contact with the extraction electrode for cathode in the sealing member 26. In this case, since the both ends of the electrode layer 20 in the Y-direction are sealed with the sealing member 26, the widths in the Y-direction of the lower layer 20A and the upper layer 20B may be equal to each other, or the width in the Y-direction of the lower layer 20A may be narrower than the width in the Y-direction of the upper layer 20B. Since the both ends of the electrode layer 20 in the Y-direction are sealed with the sealing member 26, an example of the upper layer 20B may also include a material affected by moisture. Accordingly, the degree of freedom in material selection and configuration of the electrode layer 20 is improved.

The structure of the electrode layer 20 is not limited to a two-layer structure of the lower layer 20A and the upper layer 20B. The electrode layer 20 may have a single-layer structure, or a multilayer structure of three or more layers. As a material for the electrode layer 20, materials other than those exemplified in the description of the lower layer 20A and the upper layer 20B may be used, and, for example, a conductive metal oxide or a conductive organic substance may be used.

The extending direction of the hole 22 is the second direction (Y-direction) orthogonal to the first direction (X-direction) corresponding to the arrangement direction of the plurality of device formation regions DA. However, the extending direction of the hole 22 may be a direction crossing the first direction corresponding to the arrangement direction of the plurality of device formation regions DA. In other words, the first direction and the second direction may not be orthogonal.

The flexible substrate 10 may not be long when having a size in which the plurality of device formation regions DA can be virtually set. For example, the flexible substrate may have a sheet shape. In the case in which the flexible substrate has not the long shape but the sheet shape, the flexible substrate may be conveyed in one direction (the first direction). Alternatively, in the case of the sheet shape, the flexible substrate may be subjected to the second electrode layer forming step and the like without being conveyed.

Although the case where the electrode layer on the side of the flexible substrate 10 is the anode layer is described as an example, the electrode layer on the side of the flexible substrate 10 may be a cathode layer. In this case, the second electrode function portion of the second electrode layer is an anode function portion.

In the above-described embodiment, the organic EL device as an example of the organic electronic device is described, but the present invention is applicable to not only the organic EL device but also an organic electronic device that is a device using an organic material, for example, an organic photodetector, an organic thin-film solar cell, an organic transistor, or an organic sensor.

### Reference Signs List

- 10: flexible substrate
- 14: anode layer (first electrode layer)
- 16: organic functional layer
- 20: electrode layer (second electrode layer)
- 20A: lower layer (first layer)
- 20B: upper layer (second layer)
- 22: hole
- 24: cathode function portion
- 26: sealing member
- 28, 28A: organic EL device (organic electronic device)

## Claims

1. A method for manufacturing an organic electronic device, comprising:
an organic functional layer forming step of forming organic functional layer on a first electrode layer provided in a first direction for each of a plurality of device formation regions set in a flexible substrate;
a second electrode layer forming step of forming a second electrode layer on the flexible substrate, on which the organic functional layer is formed, over the plurality of device formation regions in the first direction in such a way as to cover at least a part of each organic functional layer;
a hole forming step of forming a hole by removing, in a second direction crossing the first direction, the second electrode layer provided between a boundary of the device formation region and a function exhibiting design region in the organic functional layer in the first direction or on the boundary; and
a sealing step of providing a sealing member sealing the organic functional layer on the second electrode layer in such a way as to cover a surface of the hole on a side of the function exhibiting design region.

2. The method according to claim 1, wherein
the flexible substrate is long,
the first direction is a longitudinal direction of the flexible substrate, and
the second electrode layer forming step is performed while conveying the flexible substrate in the first direction.

3. The method according to claim 2, wherein the second electrode layer forming step and the hole forming step are performed by a roll-to-roll method.

4. The method according to any one of claims 1 to 3, wherein, in the hole forming step, the hole is formed by irradiating the second electrode layer with a laser beam and removing the second electrode layer.

5. The method according to any one of claims 1 to 4, wherein, in the sealing step, the sealing member is provided on the second electrode layer such that a part of the sealing member is filled in the hole.

6. The method according to any one of claims 1 to 5, wherein
the second electrode layer forming step includes:
a step of forming a first layer containing at least one of an alkali metal, an alkali earth metal, an alkali metal compound, and an alkali earth metal compound; and
a step of forming a second layer containing an amphoteric metal on the first layer.

7. The method according to any one of claims 1 to 6, wherein, in the hole forming step, the hole is formed outwards from the organic functional layer in the first direction.

8. The method according to any one of claims 1 to 6, wherein, in the hole forming step, the hole is formed in such a way as to be located on the organic functional layer, and located outwards from the function exhibiting design region in the first direction.

9. The method according to claim 8, wherein the hole is formed in such a way as to extend to an inside of the organic functional layer.

10. The method according to any one of claims 1 to 9, further comprising:
a dicing step of individually dicing the flexible substrate obtained through the sealing step for each of the device formation regions.

11. An organic electronic device comprising:
a flexible substrate including a first end and a second end located on a side opposite to the first end in a first direction;
a first electrode layer provided on the flexible substrate;
an organic functional layer provided on the first electrode layer;
a second electrode layer provided from the first end to the second end and covering at least a part of the organic functional layer; and
a sealing member provided on the second electrode layer and sealing the organic functional layer, wherein
at least a part of the second electrode layer on the organic functional layer is a second electrode function portion,
a hole is formed in the second electrode layer at an outside of the second electrode function portion and both sides of the second electrode function portion in the first direction, the hole extending into the second electrode layer in a second direction crossing the first direction, and
the sealing member is provided on the second electrode layer such that a part of the first electrode layer is exposed from an end of the sealing member in the second direction, and covers a surface of the hole on a side of the second electrode function portion.

12. The organic electronic device according to claim 11, wherein the hole is formed outwards from the organic functional layer in the first direction.

13. The organic electronic device according to claim 11, wherein the hole extends into the organic functional layer.

14. The organic electronic device according to any one of claims 11 to 13, wherein a part of the sealing member is filled in the hole.
